# EUROPEAN PATENT APPLICATION

(11) **EP 4 254 623 A1**
(43) Date of publication of application: **04.10.2023**
(21) Application number: 22165612.7
(22) Date of filing: 30.03.2022
(51) Int. Cl.: H01M 50/204, H01M 50/519, H01M 50/574, H01M 50/284, H01M 10/48

(54) **A BATTERY PACK, AN ELECTRIC VEHICLE AND A METHOD FOR ASSEMBLING A BATTERY PACK**

(71) Applicant: Samsung SDI Co., Ltd., Yongin-si, Gyeonggi-do 17084 (KR)
(72) Inventor: Ridisser, Markus, 8141 Premstätten (AT); Maxl, Florian, 8020 Graz (AT)
(74) Representative: Gulde & Partner

(57) **Abstract**

The present disclosure refers to a battery pack (10), comprising: a plurality of battery cells (20), at least one battery management module, BMM (21), a plurality of sensor devices (25a) and/or current collector devices (25b), a flexible conductor arrangement (22) comprising a plurality of conductor lines (14), wherein the flexible conductor arrangement (22) comprises at least one flexible printed circuit, FPC, (23, 23a, 23b) and a plurality of flexible flat cables, FFCs, (24) connected to the FPC (23, 23a, 23b), wherein the conductor lines (14) are routed along the FPC (23, 23a, 23b) and branch into the plurality of FFCs (24), and wherein each of the conductor lines (14) electrically interconnects the BMM (21) via the FPC (23, 23a, 23b) and via one of the FFCs (24) with one of the sensor devices (25a), one of the current collector devices (25b) and/or one of the battery cells (20).

## Description

### Field of the Disclosure

The present disclosure relates to a battery pack for an electric vehicle. The disclosure also relates to an electric vehicle and to a method for assembling a battery pack.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator or a hydrogen fuel power cell. Furthermore, the vehicle may include a combination of electric motor and conventional combustion engine. In general, an electric-vehicle battery, EVB, or traction battery is a battery used to power the propulsion of battery electric vehicles, BEVs. Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for electric and hybrid vehicles and the like.

Rechargeable batteries may be used as a battery module formed of a plurality of unit battery cells coupled in series and/or in parallel so as to provide a high energy content, in particular for motor driving of a hybrid vehicle. That is, the battery module is formed by interconnecting the electrode terminals of the plurality of unit battery cells depending on a required amount of power and in order to realize a high-power rechargeable battery.

Battery modules can be constructed either in block design or in modular design. In block designs each battery is coupled to a common current collector structure and a common battery management system and the unit thereof is arranged in a housing. In modular designs, pluralities of battery cells are connected to form submodules and several submodules are connected to form the battery module. In automotive applications, battery systems often consist of a plurality of battery modules connected in series for providing a desired voltage. Therein, the battery modules may comprise submodules with a plurality of stacked battery cells, each stack comprising cells connected in parallel that are connected in series (*XpYs*) or multiple cells connected in series that are connected in parallel (*XsYp*)*.*

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually comprise a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module and/or in a battery pack.

Thus, the BMS/BMU is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems, e.g., the battery pack, further comprise a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

Battery packs for electric vehicles according to the prior art comprise a plastic carrier with integrated cell-sensing devices. The information of these cell-sensing devices has to be collected via a cost intensive, complex and heavy cable arrangement which is routed through the entire battery pack to one central BMM. Alternatively, there are decentral BMMs on top of cell stacks formed by a plurality of battery cells being stack together. However, the BMMs need to be connected with each other. The BMMs and the interconnections are rigid parts which uses a valuable construction space on top of the cells. The BMMs also need to be connected to the BDU. Thus, there is a large amount of voltage and/or temperature sensing within the battery pack with a large number of cables which have to be fixed and this leads to more additional parts, e.g., cable clips.

US 2019/0296407 A1 discloses a battery module with a temperature monitoring system including temperature probes, a first and a second circuit substrate, and one or more connectors configured to interconnect with a BMS. The circuit substrates comprise a number of traces, wires, and/or other conductive elements, electrically connecting each temperature probe to the BMS. The circuit substrates may be configured as a printed circuit board, PCB, rigid PCB, flexible PCB, and/or a flexible "flex" circuit. The first circuit substrate may extend along the length of the battery module from the BMS to a sensing region of the battery module, where the first circuit substrate may split into the second circuit substrate reaching one or more temperature probes.

US 2017/0271642 A1 discloses a flexible printed circuit signal conductor system for a battery module. The signal conductor system comprises connection portions to connect to cell connectors and a temperature sensor and a signal conductor terminal connector to connect the signal conductor system to a monitoring arrangement by way of a multipolar connection line.

DE 20 2019 103 921 U1 discloses a contacting device for a battery module comprising flexible flat cables with integrated temperature sensors.

### Summary of Invention

The invention is defined by the appended claims. The description that follows is subjected to this limitation. Any disclosure lying outside the scope of said claims is only intended for illustrative as well as comparative purposes.

According to one aspect of the present disclosure, a battery pack comprises: a plurality of battery cells, at least one battery management module, BMM, a plurality of sensor devices and/or a plurality of current collector devices, a flexible conductor arrangement comprising a plurality of conductor lines, wherein the flexible conductor arrangement comprises at least one flexible printed circuit, FPC, and a plurality of flexible flat cables, FFCs, connected to the FPC, wherein the conductor lines are routed along the FPC and branch into the plurality of FFCs, and wherein each of the conductor lines electrically interconnects the BMM via the FPC and via one of the FFCs with one of the sensor devices, one of the current collector devices and/or one of the battery cells.

According to another aspect of the present disclosure, an electric vehicle comprises the battery pack according to the present disclosure.

Yet another aspect of the present disclosure refers to a method for assembling a battery pack according to the present disclosure, wherein the method comprises the steps of: a) providing a plurality of battery cells, at least one battery management module, BMM, a plurality of sensor devices and/or a plurality of current collector devices, a flexible conductor arrangement comprising a plurality of conductor lines, wherein the flexible conductor arrangement comprises at least one flexible printed circuit, FPC, and a plurality of flexible flat cables, FFCs, connected to the FPC, wherein the conductor lines are routed along the FPC and branch into the plurality of FFCs, and b) electrically interconnecting each of the sensor devices, current collector devices and/or battery cells with the BMM by one of the conductor lines via the FPC and via one of the FFCs.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic view of an electric vehicle according to an embodiment of the invention.
- Fig. 2: illustrates a section of a perspective view of a battery pack according to an embodiment.
- Fig. 3: illustrates a section of a top view of a battery pack according to an embodiment.
- Fig. 4: illustrates a section of a perspective view of a battery pack according to another embodiment.
- Fig. 5: illustrates a perspective view of a flexible conductor arrangement.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

### General Concept

According to one aspect of the present disclosure, a battery pack comprises: a plurality of battery cells, at least one battery management module, BMM, a plurality of sensor devices and/or a plurality of current collector devices, a flexible conductor arrangement comprising a plurality of branched conductor lines. The at least one BMM is adapted to obtain and process information acquired by the plurality of sensor devices. Each of the current collector devices is adapted to deliver an electric current from one or more of the battery cells to the at least one BMM.

The flexible conductor arrangement comprises the plurality of branched conductor lines. Thus, the conductor lines are flexible and can be arranged effectively at different positions within the battery pack. The conductor lines are branched, i.e., a plurality of the conductor lines comprises a first section in which the plurality of the conductor lines is arranged at, i.e., routed along, essentially the same path, e.g., individual conductor lines of the plurality of the conductor lines are arranged in parallel to each other while being electrically isolated from each other, and the plurality of the conductor lines comprises a second section in which the plurality of conductor lines are arranged at different paths through the battery pack. A branch portion is arranged between the first section and the second section at which individual conductor lines of the plurality of conductor lines branch of each other.

The flexible conductor arrangement comprises at least one flexible printed circuit, FPC, and a plurality of flexible flat cables, FFCs, connected to the FPC. Therein, the FPC comprises a flexible substrate and is adapted to provide a portion of the conductor lines. The FFC is an electric cable that is flat and flexible and is adapted to provide a portion of the conductor lines. The conductor lines are routed along the FPC and the FFCs. Each of the conductor lines branch at a branch portion of the FPC into one of the plurality of FFCs. Thus, the FPC comprises a plurality of branch portions, and at each of the branch portions the FPC branches into one of the plurality of FFCs. Thus, the FPC provides the above mentioned first section in which the plurality of conductor lines are arranged in parallel to each other, and the FFCs provide the second section in which the plurality of conductor lines are arranged at different paths. The flexible conductor arrangement comprising the FPC and the plurality of FFCs combines the advantages of an FPC as such and of FFCs as such, namely the FPC allows an effective arrangement of conductor lines and the FFCs allow a cost-effectively and efficiently manufacturable arrangement of conductor lines.

Each of the conductor lines electrically interconnects the BMM via the FPC and via one of the FFCs with one of the sensor devices, one of the current collector devices and/or one of the battery cells. The FPC acts as a collector for all the conductor lines and routes the conductor lines to the at least one BMM to reduce wiring. In other words, the invention suggests a cell-sensing and current collection concept via an FFC and FPC combination for a flexible positioning of the at least one BMM. The invention provides a flexible conductor arrangement which combines the advantages of FPCs, namely a plurality of parallel conductor lines which can be effectively arranged, and FFCs, namely cost-efficiently and an effective manufacturability. Plastic parts and cables which are required for holding battery packspanning busbars and cell sensing devices can be dispensed with. The FPC is adaptable to the shape and geometry of the substrate below the FPC, i.e., battery cells, a longitudinal beam and/or a crossbeam, and is easily to fixate mechanically. Thus, wiring in the entire battery pack can be reduced to a minimum, irrespective of the installation position of the at least one BMM. The number of plugs and additional electrical components can be reduced in order to save weight and costs and to decrease the complexity of the battery pack and its manufacturability.

According to one embodiment, the FPC comprises a plurality of electrically conducting layers being separated from each other by at least one electrically isolating layer. I.e., one electrically isolated layer is arranged between any pair of electrically conducting layers. This allows to arrange a plurality of conductor lines within the FPC efficiently and in a space-saving manner. Compared to a single conducting layer or a flat cable, by providing the plurality of electrically conducting layers the number of conductor lines can be increased by a factor of the number of electrically conducting layers. Optionally, the number of electrically conducting layers equals the number of FFCs or the number of conductor lines being provided by a single FFC. This further reduces wiring and simplifies the connection between the FPC and the FFCs.

According to one embodiment, to each of the electrically conducting layers of the FPC one of the plurality of FFCs is electrically connected. This is particularly space-saving as the width of the FPC does not need to depend on the number of FFCs connected to the FPC.

According to one embodiment, the battery cells are electrically interconnected by a busbar, and the FPC comprises a metal portion arranged at a welding position and being electrically isolated from the conductor lines and being welded to the busbar and/or the busbar comprises a metal portion arranged at a welding position and being electrically isolated from the conductor lines and being welded to the FPC. This enables a reliable mechanical fixation of the flexible conductor arrangement within the battery pack. The metal portion being electrically isolated from the conductor lines avoids any unintended interference of electrical currents flowing through the busbar and the conducting lines.

According to one embodiment, each of the FFCs is electrically connected to a plurality of the sensor devices, current collector devices and/or battery cells. This enables an efficient routing of the conductor lines as each of the FFCs comprises a plurality of conductor lines which can be routed by the FFC. Optionally, each of the FFCs is electrically connected to a number of the sensor devices, current collector devices and/or battery cells that equals the number of conductor lines provided by the respective FFC.

According to one embodiment, the battery cells and the sensor devices and/or current collector devices are arranged in a plurality of cell stacks, and the FPC is arranged to reach the plurality of cell stacks. Thus, battery cells are arranged in a stacked manner. Between the battery cells and/or between cell stacks the sensor devices are arranged. The FPC is arranged so that the conductor lines can be routed via the FFCs to each of the cell stacks. I.e., the FPC is elongated along an extension direction so that the FPC is arranged to span over the cell stacks which are connected to the FPC. This allows an efficient arrangement of the FPC and ensures that any functional entity, i.e., the battery cells, the sensor devices, and/or current collector devices, can be electrically interconnected with the BMM in an efficient manner.

According to one embodiment, each of the FFCs is electrically connected to the battery cells, the sensor devices and/or the current collector devices of the same battery cell stack. This is particularly efficient as the FFCs can be arranged to extend in an extension direction of the battery cell stack. Thus, the FPC is arranged so that every cell stack is reached and the FFCs branching of the FPC and extend and are arranged so that any functional entity within the cell stack is reached.

According to one embodiment, the at least one flexible conductor arrangement is electrically connected to a single BMM. I.e., the BMM is interconnected to the battery cells, the sensor devices, and/or the current collector devices via the at least one FPC and a plurality of FFCs. Thus, only the at least one FPC needs to be connected to the central BMM which enables an efficient layout and manufacture of the battery pack.

According to one embodiment, the battery pack comprises a battery disconnect unit, BDU, and the BDU comprises the BMM. This facilitates an efficient layout of the battery pack and further simplifies routing of the FPC.

According to one embodiment, each of the at least one FPC and the plurality of FFCs comprises an elongated shape defining a principal extension direction, and the FPC and the plurality of FFCs are arranged so that the principal extension direction of the FPC is perpendicular to the principal extension direction of each of the plurality of FFCs. I.e., each of the FFCs is arranged perpendicular to the FPC. This allows an efficient arrangement of the flexible conductor arrangement by routing the FPC so that the FPC reaches each of the cell stacks and by routing the FFCs so that the FFCs reach functional entities to be contacted at one of the cell stacks, each.

According to one embodiment, the FPC comprises an electrical connector to electrically interconnect the FPC and the BMM with each other in a reversible manner. This enables that the BMM can be easily dismounted from and mounted to the battery pack, e.g., for maintenance.

According to one embodiment, each of the FFCs is welded to the FPC. The FFCs can be welded at the branch portions to the FPC. Each of the branch portions comprises a plurality of contact portions at which one of the conducting lines provided by one of the FFCs can be welded. This enables an efficient and reliable electrical interconnection between the FPC and the FFCs.

According to one embodiment, the FPC comprises an electronics device. The electronics device can comprise a data processing device and/or a sensing device that process and/or acquire data. The data processing device can be used to evaluate signals being acquired by the sensor devices within the cell stacks and transmit evaluation results to the BMM. This can reduce and/or make more efficient the data transfer between the sensor devices and the BMM.

According to another aspect of the present disclosure, an electric vehicle comprises the battery pack according to the present disclosure. The battery pack of the electric vehicle can comprise any of the aforementioned optional features to achieve the technical effects associated therewith.

Yet another aspect of the present disclosure refers to a method for assembling a battery pack according to the present disclosure, wherein the method comprises the steps of: a) providing a plurality of battery cells, at least one battery management module, BMM, a plurality of sensor devices and/or current collector devices, a flexible conductor arrangement comprising a plurality of branched conductor lines, wherein the flexible conductor arrangement comprises at least one flexible printed circuit, FPC, and a plurality of flexible flat cables, FFCs, connected to the FPC, wherein the conductor lines are routed along the FPC and branch into the plurality of FFCs, and b) electrically interconnecting each of the sensor devices and/or current collector devices with the BMM by one of the conductor lines via the FPC and via one of the FFCs. The method can comprise methods steps to assemble a battery pack comprising any of the aforementioned optional features to achieve the technical effects associated therewith. In particular, the flexible conductor arrangement can comprise any of the aforementioned optional features to achieve the technical effects associated therewith.

### Specific Embodiments

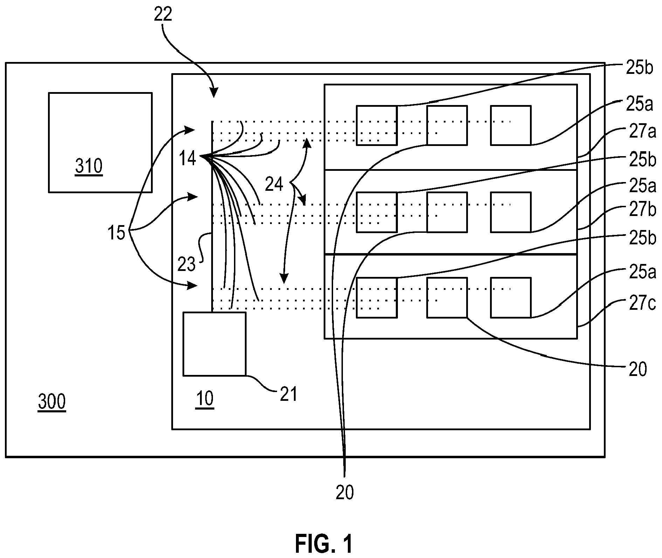

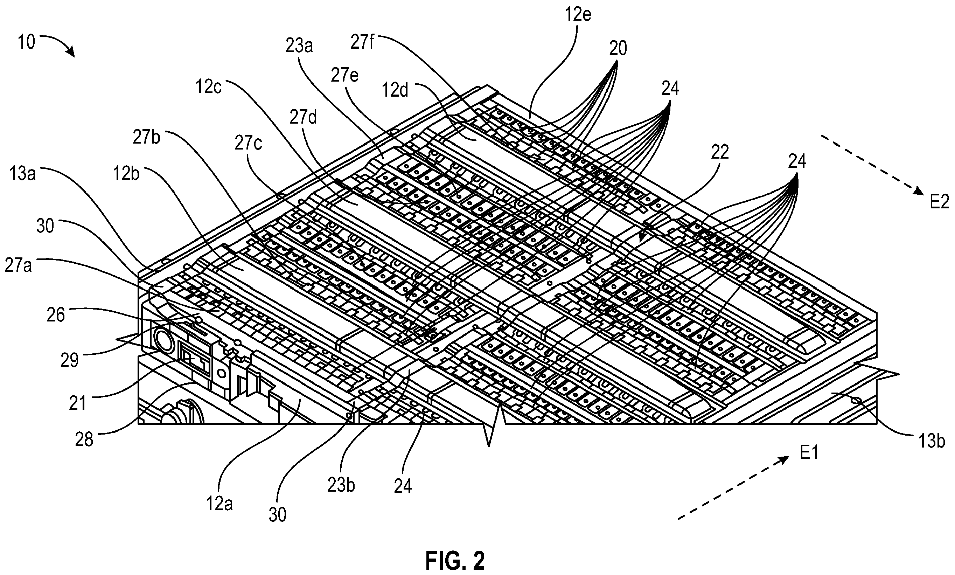

Figure 1 illustrates a schematic view of an electric vehicle 300 according to an embodiment of the invention. The electric vehicle 300 is propelled by an electric motor 310, using energy stored in rechargeable batteries cells 20 arranged in a battery pack 10. The battery cells 20 are arranged in a stacked manner in cell stacks 27a, 27b, 27c (in Figure 1, only one battery cell 20 per cell stack 27a, 27b, 27c is indicated for an illustrative purpose; see Figures 2 to 4 for a more realistic representation).

The battery pack 10 comprises a battery management module, BMM, 21 a plurality of sensor devices 25a and a plurality of current collector devices 25b. The current collector devices 25b can be adapted to electrically interconnect a subset of the battery cells 20 within one of the cell stacks 27a, 27b, 27c with each other (not shown in Fig. 1). E.g., a current collector device 25b can be adapted electrically interconnect six battery cells 20 within one of the cell stacks 27a, 27b, 27c with each other. This reduces the number of conductor lines that is necessary to obtain the electrical power of the battery cells 20 as compared to connecting each of the battery cells 20 individually. The sensor devices 25a comprise temperature sensing devices, wherein each of the temperature sensing devices is adapted to measure the temperature within the battery pack 10, in particular as shown in Figure 1 within one of the cell stacks 27a, 27b, 27c, e.g., the temperature of one of the battery cells 20, or between a pair of cell stacks 27a, 27b, 27c.

To electrically connect the battery cells 20, the sensor devices 25a and the current collector devices 25b with the BMM 21, the battery pack 10 comprises a flexible conductor arrangement 22 comprising a plurality of branched conductor lines 14.

The flexible conductor arrangement 22 comprises a flexible printed circuit, FPC, 23 and a plurality of flexible flat cables, FFCs, 24 connected to the FPC 23. The FPC 23 is indicated by a dashed line. The FPC 23 comprises a plurality of branch portions 15. At each of the branch portions 15 one of the FFCs 24 is connected to the FPC 23. The FPC 23 and the FFCs 24 provide the conductor lines 14.

The conductor lines 14 are routed along the FPC 23 and branch at the branch portions 15 into the plurality of FFCs 24. Each of the FFCs 24 is indicated by the plurality of conductor lines 14 with dotted lines. Thus, at each of the branch portions 15 the plurality of conductor lines 14 are routed from the FPC 23 to one of the FFCs 24. Each of the conductor lines 14 electrically connects the BMM 21 via the FPC 23 and via one of the FFCs 24 with one of the sensor devices 25a, one of current collector devices 25b and/or one of the battery cells 20.

Figure 2 illustrates a section of a perspective view of a battery pack 10 according to an embodiment.

The battery pack 10 comprises a battery management module, BMM, 21 and a battery disconnect unit, BDU 28. Therein, the BDU 28 comprises the BMM 21. Thus, to obtain and process any data being acquired within the battery pack 10, only one central BMM 21 is provided by the battery pack 10.

The battery pack 10 comprises a plurality of sensor devices 25a (not shown in Fig. 2), a plurality of current collector devices 25b (not shown in Fig. 2), and a plurality of battery cells 20. The battery cells 20, the sensor devices 25a and the current collector devices 25b are arranged in a plurality of cell stacks 27a, 27b, 27c, 27d, 27e, 27f. Therein, each of the current collector devices 25b is adapted to electrically interconnect a subset of the battery cells 20 within one of the cell stacks 27a, 27b, 27c, 27d, 27e, 27f with each other.

The battery pack 10 comprises a flexible conductor arrangement 22 arranged to span the battery module 10 so that each of the cell stacks 27a, 27b, 27c, 27d, 27e, 27f is reached by the flexible conductor arrangement 22. The flexible conductor arrangement 22 comprises a plurality of conductor lines 14 (not indicated in Figure 2, see Figure 1 for a schematic illustration).

The flexible conductor arrangement 22 comprises two flexible printed circuits, FPCs, 23a, 23b and a plurality of flexible flat cables, FFCs, 24. In this embodiment, the FPCs 23a, 23b are of different type. I.e., the shape and geometry of the FPCs 23a, 23b is essentially equal, except one of the FPCs 23a comprises a connection portion 29 to connect the FPC 23a to the BDU 28.

Each of the FFCs 24 is connected to one of the FPCs 23a, 23b. Each of the FPCs 23a, 23b comprises a plurality of branch portions 15 (see Figures 1, 3 and 5). At each of the branch portions 15 one of the FFCs 24 is connected to the corresponding FPC 23a, 23b. The FPCs 23a, 23b and the FFCs 24 provide the plurality of conductor lines 14. To electrically connect the battery cells 20, the sensor devices 25a and the current collector devices 25b with the BMM 21, the plurality of branched conductor lines 14 is provided by the FPCs 23a, 23b and the FFCs 24.

The conductor lines 14 are routed along the FPCs 23a, 23b and branch at the branch portions 15 into the plurality of FFCs 24. Thus, at each of the branch portions 15 of each of the FPCs 23a, 23b conductor lines 14 are routed from the corresponding FPC 23a, 23b to one of the FFCs 24. The number of branch portions 15 equals the number of FFCs 24. Each of the conductor lines 14 electrically interconnects the BMM 21 via one of the FPC 23a, 23b and via one of the FFCs 24 with one of the sensor devices 25a, one of current collector devices 25b and/or one of the battery cells 20.

Each of the FPCs, 23a, 23b comprises a plurality of electrically conducting layers being separated from each other by an electrically isolating layer, each (not shown in the Figure). Each of the FFCs 24 is electrically connected to one of the electrically conducting layers of one of the FPCs, 23a, 23b and to each of the electrically conducting layers of each of the FPCs 23a, 23b one of the FFCs 24 is connected. Thus, due to the FPCs 23a, 23b providing the plurality of electrically conducting layer the FPCs 23a, 23b can comprise a comparably small width as the conductor lines 14 are arranged in the plurality of electrically conducting layers instead of only in one electrically conducting layer. Each of the FFCs 24 is welded to the FPC 23 at one of the branch portions 15.

The battery cells 20 are electrically interconnected by a busbar 26, and each of the FPCs, 23a, 23b comprises a metal portion arranged at a welding position 30 and being electrically isolated from the conductor lines 14 and being welded to the busbar 26.

Each of the FFCs 24 is electrically connected to a plurality of the sensor devices 25a, current collector devices 25b and/or battery cells 20. The FPCs 23a, 23b are arranged to reach each of the plurality of cell stacks 27a, 27b, 27c, 27d, 27e, 27f. Each of the FFCs 24 is electrically connected to the battery cells 20, the sensor devices 25a and/or the current collector devices 25b of the same battery cell stack 27a, 27b, 27c, 27d, 27e, 27f.

The FPCs 23a, 23b and the plurality of FFCs 24 comprise an elongated shape defining a principal extension direction E1, E2, each. I.e., the FPCs 23a, 23b are arranged to mainly extend along a first extension direction E1, and the plurality of FFCs 24 is arranged to mainly extend along a second extension direction E2. The FPCs 23a, 23b and the plurality of FFCs 24 is arranged so that the first extension direction E1 of the FPCs 23a, 23b is perpendicular to the second extension direction E2 of each of the plurality of FFCs 24. I.e., at each of the branch portions 15 one of the FFCs 24 branches of from one of the FPCs 23a, 23b to extend perpendicular from the respective FPC 23a, 23b. Each of the first extension direction E1 and the second extension direction E2 is indicated in the figures by a dashed arrow.

Each of the FFCs 24 being commonly connected to one of the FPCs 23a, 23b are arranged at the same site of the respective FPC 23a, 23b. I.e., the FFCs 24 do not branch of the FPC 23a, 23b in opposing directions but in the same direction and parallel to each other.

The FPC 23a comprises an electrical connector to electrically interconnect the FPC 23a and the BMM 21 with each other in a reversible manner at the connection portion 29.

The battery pack 10 comprises six rows of cell stacks 27a, 27b, 27c, 27d, 27e, 27f in the shown embodiment. To provide structural support for the battery pack 10 and for retaining the cell stacks 27a, 27b, 27c, 27d, 27e, 27f, the battery pack 10 comprises two longitudinal beams 13a, 13b and a plurality of crossbeams 12a, 12b, 12c, 12d, 12e arranged between and connected to the longitudinal beams 13a, 13b.

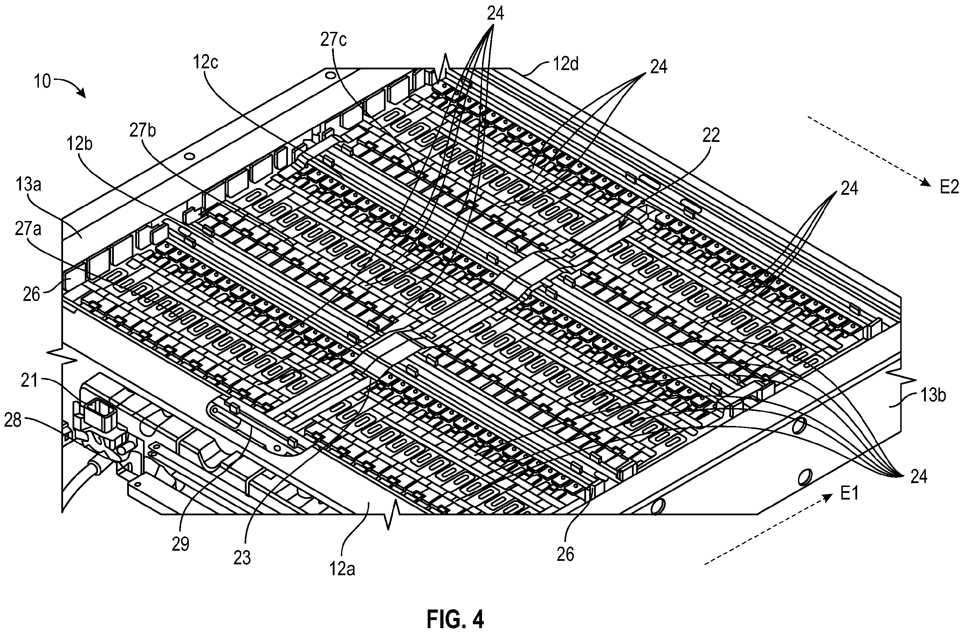

The crossbeams 12a, 12b, 12c, 12d, 12e are arranged in parallel to each other and the plurality of crossbeams 12a, 12b, 12c, 12d, 12e comprises two outer crossbeams 12a, 12e and, in this embodiment, three inner crossbeams 12b, 12c, 12d. It is possible that a battery pack 10 comprises a different number of crossbeams 12a, 12b, 12c, 12d and/or differently-sized longitudinal beams 13a, 13b to provide a differently sized battery pack 10 (see, e.g., Figure 4).

The cell stacks 27a, 27b, 27c, 27d, 27e, 27f and the three inner crossbeams 12b, 12c, 12d are alternately stacked between the two outer crossbeams 12a, 12e. Compartments to retain the cell stacks 27a, 27b, 27c, 27d, 27e, 27f are provided between any neighboring pair of crossbeams 12a, 12b, 12c, 12d, 12e.

The length of each of the crossbeams 12a, 12b, 12c, 12d, 12e in the second extension direction E2 pointing from one of the longitudinal beams 13a to the other longitudinal beam 13b matches the length of the rows of cell stacks 27a, 27b, 27c, 27d, 27e, 27f so that the rows of cell stacks 27a, 27b, 27c, 27d, 27e, 27f can be arranged and retained between the pairs of crossbeams 12a, 12b, 12c, 12d, 12e.

The two longitudinal beams 13a, 13b are arranged in parallel to each other, and each of the two longitudinal beams 13a, 13b is elongated along the first extension direction E1. The crossbeams 12a, 12b, 12c, 12d, 12e are arranged in parallel to each other, and each of the crossbeams 12a, 12b, 12c, 12d, 12e is elongated along the second extension direction E2. I.e., the crossbeams 12a, 12b, 12c, 12d, 12e and the two longitudinal beams 13a, 13b are arranged perpendicular to each other. Thus, compartments with a rectangular cross-section to retain the cell stacks 27a, 27b, 27c, 27d, 27e, 27f are formed in the battery pack 10.

Each of the crossbeams 12a, 12b, 12c, 12d, 12e is connected to the two longitudinal beams 13a, 13b by a plurality of fasteners (not shown) extending into the second extension direction E2 through the longitudinal beams 13a, 13b and into the crossbeams 12a, 12b, 12c, 12d, 12e. The longitudinal beams 13a, 13b comprise openings through which the fasteners extend into the crossbeams 12a, 12b, 12c, 12d, 12e.

The longitudinal beams 13a, 13b and the crossbeams 12a, 12b, 12c, 12d, 12e are extruded beams. The number of inner crossbeams 12b, 12c, 12d equals the number of cell stacks 27a, 27b, 27c, 27d, 27e, 27f minus one. Each of the cell stacks 27a, 27b, 27c, 27d, 27e, 27f is mounted between a pair of adjacent crossbeams 12a, 12b, 12c, 12d, 12e.

In this embodiment, the whole data transfer between the sensor devices 25a, one of current collector devices 25b and/or one of the battery cells 20 and the BMM 21 can be routed via the flexible conductor arrangement 22 over venting channels which can be fulfilled with the flexible conductor arrangement 22.

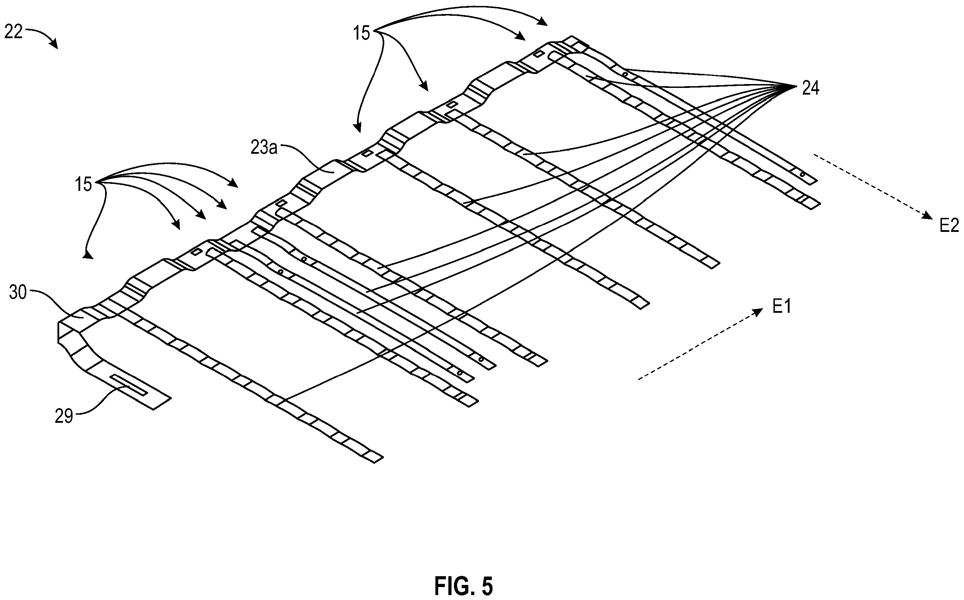

The FPCs 23a, 23b comprise a non-planer shape. I.e., the FPCs 23a, 23b can be shaped and arranged to match the shape of a contacting surface between the FPCs 23a, 23b and any underlying components of the battery pack 10, in particular of the cell stacks 27a, 27b, 27c, 27d, 27e, 27f and crossbeams 12a, 12b, 12c, 12d, 12e (see also Fig. 5).

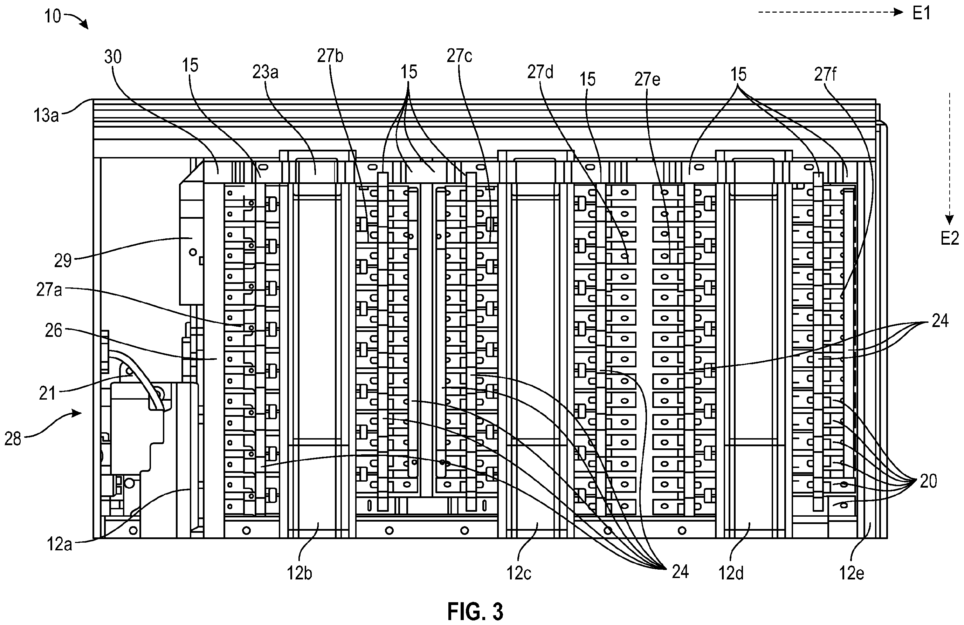

Figure 3 illustrates a section of a top view of the battery pack 10 as shown in Figure 2 and described with reference thereto. The section of the top view of the battery pack 10 illustrates the arrangement of the flexible conductor arrangement 22 with regard to the FPC 23a and the FFCs 24 connected thereto. In particular, the FPC 23a and the FFCs 24 are arranged to extend perpendicular to each other. The FPC 23a is arranged to span over each of the cell stacks 27a, 27b, 27c, 27d, 27e, 27f, i.e., the extension of the FPC 23a along the first extension direction E1 matches the width of the cell stacks 27a, 27b, 27c, 27d, 27e, 27f and the crossbeams 12b, 12c, 12d arranged between the cell stacks 27a, 27b, 27c, 27d, 27e, 27f. The FPC 23a comprises a number of branch portions 15 that is larger than the number of cell stacks 27a, 27b, 27c, 27d, 27e, 27f. Thus, at each of the cell stacks 27a, 27b, 27c, 27d, 27e, 27f at least one of the FFCs 24 branches of the FPC 23a to reach in the cell stacks 27a, 27b, 27c, 27d, 27e, 27f and connect to one of the sensor devices 25a, one of current collector devices 25b and/or one of the battery cells 20 of the respective cell stack 27a, 27b, 27c, 27d, 27e, 27f. E.g., to provide conductor lines 14 for temperature measurement by the sensor devices 25a and for current collection by the current collector devices 25b within the same cell stack 27b, 27c, 27f, two branch portions 15 are provided so that two of the FFCs 24 reach the respective cell stack 27b, 27c, 27f.

Figure 4 illustrates a section of a perspective view of a battery pack 10 according to another embodiment.

The battery pack 10 of Figure 4 is described with reference to the embodiment of Figures 2 and 3, wherein the differences between the embodiments are described.

The battery pack 10 comprises a flexible conductor arrangement 22, wherein the flexible conductor arrangement 22 comprises one FPC 23. The FPC 23 is centrally arranged. I.e., the FPC 23 is arranged in a central section of each of the battery cell stacks 27a, 27b, 27c and of the crossbeams 12a, 12b, 12c. The FFCs 24 being connected the FPC are arranged at the opposite sites of the FPC 23. I.e., the FFCs 24 branch of the FPC 23 in opposing directions and parallel to each other. The FFCs 24 branch of in pairs, i.e., at each branch portion 15 of the FPC 23, a pair of FFCs 24 branches of the FPC 23 in opposite directions.

The battery pack 10 comprises a smaller number of crossbeams 12a, 12b, 12c, 12d and of cell stacks 27a, 27b, 27c as compared to the embodiment of Figures 2 and 3.

Figure 5 illustrates a perspective view of a flexible conductor arrangement 22. The flexible conductor arrangement 22 is described with reference to the embodiment of Figures 2 and 3.

In Figure 5, the branch portions 15 are indicated. At each of the branch portion 15, one of the FFCs 24 is arranged to extend perpendicular from the FPC 23a.

The FPCs 23a comprise a non-planer shape. I.e., the FPC 23a is flexible and arranged and/or shaped to match the shape of a contacting surface between the FPC 23a and any underlying components of the battery pack 10 (not shown). Thus, along the first extension direction E1, the FPC 23a comprises an undulating shape, i.e., the FPC 23a extends in an alternating manner in a direction being perpendicular to the first extension direction E1 and to the second extension direction E2.

Along the first extension direction E1, the branch portions 15 are distributed with different distances from each other. I.e., the FFCs 24 branch of the FPC 23a in different distances from each other to provide an arrangement of conducting lines 14 specific for the battery pack 10.

### Reference signs

- 10: battery pack
- 12a, 12b, 12c, 12d, 12e: crossbeam
- 13a, 13b: longitudinal beam
- 14: conductor line
- 15: branch portion

- 21: battery management module, BMM
- 22: flexible conductor arrangement
- 23, 23a, 23b: flexible printed circuit, FPC
- 24: flexible flat cable, FFC
- 25a: sensor device
- 25b: current collector device
- 26: busbar
- 27a, 27b, 27c, 27d, 27e, 27f: cell stack
- 28: battery disconnect unit, BDU
- 29: connection portion
- 30: welding position

- E1, E2: extension direction

- 300: electric vehicle
- 310: electric motor

## Claims

1. A battery pack (10), comprising:
- a plurality of battery cells (20), at least one battery management module, BMM (21), a plurality of sensor devices (25a) and/or a plurality of current collector devices (25b), a flexible conductor arrangement (22) comprising a plurality of conductor lines (14), wherein
- the flexible conductor arrangement (22) comprises at least one flexible printed circuit, FPC, (23, 23a, 23b) and a plurality of flexible flat cables, FFCs, (24) connected to the FPC (23, 23a, 23b), wherein
- the conductor lines (14) are routed along the FPC (23, 23a, 23b) and branch into the plurality of FFCs (24), and wherein
- each of the conductor lines (14) electrically interconnects the BMM (21) via the FPC (23, 23a, 23b) and via one of the FFCs (24) with one of the sensor devices (25a), one of the current collector devices (25b) and/or one of the battery cells (20).

2. The battery pack as claimed in claim 1, wherein the FPC (23, 23a, 23b) comprises a plurality of electrically conducting layers being separated from each other by at least one electrically isolating layer.

3. The battery pack as claimed in claim 2, wherein to each of the electrically conducting layers of the FPC (23, 23a, 23b) one of the plurality of FFCs (24) is electrically connected.

4. The battery pack as claimed in any one of the preceding claims, wherein
- the battery cells (20) are electrically interconnected by a busbar (26), and
- the FPC (23, 23a, 23b) comprises a metal portion arranged at a welding position (30) and being electrically isolated from the conductor lines (14) and being welded to the busbar (26) and/or the busbar (26) comprises a metal portion arranged at a welding position (30) and being electrically isolated from the conductor lines (14) and being welded to the FPC (23, 23a, 23b).

5. The battery pack as claimed in any one of the preceding claims, wherein each of the FFCs (24) is electrically connected to a plurality of the sensor devices (25a), current collector devices (25b) and/or battery cells (20).

6. The battery pack as claimed in any one of the preceding claims, wherein
- the battery cells (20) and the sensor devices (25a) and/or current collector devices (25b) are arranged in a plurality of cell stacks (27a, 27b, 27c, 27d, 27e, 27f), and
- the FPC (23, 23a, 23b) is arranged to reach the plurality of cell stacks (27a, 27b, 27c, 27d, 27e, 27f).

7. The battery pack as claimed in claim 6, wherein each of the FFCs (24) is electrically connected to the battery cells (20), the sensor devices (25a) and/or the current collector devices (25b) of the same battery cell stack (27a, 27b, 27c, 27d, 27e, 27f)

8. The battery pack as claimed in any one of the preceding claims, wherein the at least one flexible conductor arrangement (22) is electrically connected to a single BMM (21).

9. The battery pack as claimed in any one of the preceding claims, wherein the battery pack (10) further comprises a battery disconnect unit, BDU (28), and the BDU (28) comprises the BMM (21).

10. The battery pack as claimed in any one of the preceding claims, wherein
- each of the at least one FPC (23, 23a, 23b) and the plurality of FFCs (24) comprises an elongated shape defining a principal extension direction (E1, E2), and
- the at least one FPC (23, 23a, 23b) and the plurality of FFCs (24) are arranged so that the principal extension direction (E1) of the FPC (23, 23a, 23b) is perpendicular to the principal extension direction (E2) of each of the plurality of FFCs (24).

11. The battery pack as claimed in any one of the preceding claims, wherein the FPC (23a) comprises an electrical connector to electrically interconnect the FPC (23a) and the BMM (21) with each other in a reversible manner.

12. The battery pack as claimed in any one of the preceding claims, wherein each of the FFCs (24) is welded to the FPC (23, 23a, 23b).

13. The battery pack as claimed in any one of the preceding claims, wherein the FPC (23, 23a, 23b) comprises an electronics device.

14. An electric vehicle (300) comprising the battery pack (10) according to any one of the preceding claims.

15. A method for assembling a battery pack (10) as claimed in any one of claims 1 to 13, wherein the method comprises the steps of:
a) providing a plurality of battery cells (20), at least one battery management module, BMM (21), a plurality of sensor devices (25a) and/or a plurality of current collector devices (25b), a flexible conductor arrangement (22) comprising a plurality of conductor lines (14), wherein the flexible conductor arrangement (22) comprises at least one flexible printed circuit, FPC, (23, 23a, 23b) and a plurality of flexible flat cables, FFCs, (24) connected to the FPC (23, 23a, 23b), wherein the conductor lines (14) are routed along the FPC (23, 23a, 23b) and branch into the plurality of FFCs (24), and
b) electrically interconnecting each of the sensor devices (25a) current collector devices (25b) and/or battery cells (20) with the BMM (21) by one of the conductor lines (14) via the FPC (23, 23a, 23b) and via one of the FFCs (24).

## Amended claims

### Amended claims in accordance with Rule 137(2) EPC.

1. A battery pack (10), comprising:
- a plurality of battery cells (20), at least one battery management module, BMM (21), a plurality of sensor devices (25a) and/or a plurality of current collector devices (25b), a flexible conductor arrangement (22) comprising a plurality of conductor lines (14), wherein
- the flexible conductor arrangement (22) comprises at least one flexible printed circuit, FPC, (23, 23a, 23b) and a plurality of flexible flat cables, FFCs, (24) connected to the FPC (23, 23a, 23b), wherein
- the conductor lines (14) are routed along the FPC (23, 23a, 23b) and branch into the plurality of FFCs (24), and wherein
- each of the conductor lines (14) electrically interconnects the BMM (21) via the FPC (23, 23a, 23b) and via one of the FFCs (24) with one among the sensor devices (25a), the current collector devices (25b) and the battery cells (20),
**characterized in that**
the FPC (23, 23a, 23b) comprises a plurality of electrically conducting layers being separated from each other by at least one electrically isolating layer.

2. The battery pack as claimed in claim 1, wherein to each of the electrically conducting layers of the FPC (23, 23a, 23b) one of the plurality of FFCs (24) is electrically connected.

3. The battery pack as claimed in any one of the preceding claims, wherein
- the battery cells (20) are electrically interconnected by a current collector device (25b, 26) of the plurality of current collector devices (25b, 26), and
- the FPC (23, 23a, 23b) comprises a metal portion arranged at a welding position (30) and being electrically isolated from the conductor lines (14) and being welded to the current collector device (25b, 26) and/or the current collector device (25b, 26) comprises a metal portion arranged at a welding position (30) and being electrically isolated from the conductor lines (14) and being welded to the FPC (23, 23a, 23b).

4. The battery pack as claimed in any one of the preceding claims, wherein each of the FFCs (24) is electrically connected to a plurality of the sensor devices (25a), current collector devices (25b) and/or battery cells (20).

5. The battery pack as claimed in any one of the preceding claims, wherein
- the battery cells (20) and the sensor devices (25a) and/or current collector devices (25b) are arranged in a plurality of cell stacks (27a, 27b, 27c, 27d, 27e, 27D, and
- the FPC (23, 23a, 23b) is arranged to reach the plurality of cell stacks (27a, 27b, 27c, 27d, 27e, 27D.

6. The battery pack as claimed in claim 6, wherein each of the FFCs (24) is electrically connected to the battery cells (20), the sensor devices (25a) and/or the current collector devices (25b) of the same battery cell stack (27a, 27b, 27c, 27d, 27e, 27f)

7. The battery pack as claimed in any one of the preceding claims, wherein the flexible conductor arrangement (22) is electrically connected to a single BMM (21).

8. The battery pack as claimed in any one of the preceding claims, wherein the battery pack (10) further comprises a battery disconnect unit, BDU (28), and the BDU (28) comprises the BMM (21).

9. The battery pack as claimed in any one of the preceding claims, wherein
- each of the at least one FPC (23, 23a, 23b) and the plurality of FFCs (24) comprises an elongated shape defining a principal extension direction (E1, E2), and
- the at least one FPC (23, 23a, 23b) and the plurality of FFCs (24) are arranged so that the principal extension direction (E1) of the FPC (23, 23a, 23b) is perpendicular to the principal extension direction (E2) of each of the plurality of FFCs (24).

10. The battery pack as claimed in any one of the preceding claims, wherein the FPC (23a) comprises an electrical connector to electrically interconnect the FPC (23a) and the BMM (21) with each other in a reversible manner.

11. The battery pack as claimed in any one of the preceding claims, wherein each of the FFCs (24) is welded to the FPC (23, 23a, 23b).

12. The battery pack as claimed in any one of the preceding claims, wherein the FPC (23, 23a, 23b) comprises an electronics device.

13. An electric vehicle (300) comprising the battery pack (10) according to any one of the preceding claims.

14. A method for assembling a battery pack (10) as claimed in any one of claims 1 to 12, wherein the method comprises the steps of:
a) providing a plurality of battery cells (20), at least one battery management module, BMM (21), a plurality of sensor devices (25a) and/or a plurality of current collector devices (25b), a flexible conductor arrangement (22) comprising a plurality of conductor lines (14), wherein the flexible conductor arrangement (22) comprises at least one flexible printed circuit, FPC, (23, 23a, 23b) and a plurality of flexible flat cables, FFCs, (24) connected to the FPC (23, 23a, 23b), wherein the conductor lines (14) are routed along the FPC (23, 23a, 23b) and branch into the plurality of FFCs (24), and
b) electrically interconnecting each of the sensor devices (25a) current collector devices (25b) and/or battery cells (20) with the BMM (21) by one of the conductor lines (14) via the FPC (23, 23a, 23b) and via one of the FFCs (24).
